(19) Europäisches Patentamt / European Patent Office / Office européen des brevets

(11) **EP 4 027 525 B1**

(12) **EUROPEAN PATENT SPECIFICATION**

(45) Date of publication and mention
of the grant of the patent:
**10.09.2025   Bulletin 2025/37**

(21) Application number: **20870487.4**

(22) Date of filing: **24.07.2020**

(51) International Patent Classification (IPC):
**H03M 13/11** *(2006.01)*

(52) Cooperative Patent Classification (CPC):
**H03M 13/112; H03M 13/114; H03M 13/116;**
**H03M 13/616**

(86) International application number:
**PCT/CN2020/104335**

(87) International publication number:
**WO 2021/063091 (08.04.2021 Gazette 2021/14)**

(54) **DATA PROCESSING METHOD AND DECODER**

DATENVERARBEITUNGSVERFAHREN UND -DECODER

PROCÉDÉ DE TRAITEMENT DE DONNÉES ET DÉCODEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2019   CN 201910945369**

(43) Date of publication of application:
**13.07.2022   Bulletin 2022/28**

(73) Proprietor: **Huawei Technologies Co., Ltd.**
**Longgang District**
**Shenzhen,**
**Guangdong 518129 (CN)**

(72) Inventors:
• **ZHANG, Yuanxiang**
**Shenzhen, Guangdong 518129 (CN)**
• **ZHOU, Yang**
**Shenzhen, Guangdong 518129 (CN)**

(74) Representative: **Epping - Hermann - Fischer**
**Patentanwaltsgesellschaft mbH**
**Schloßschmidstraße 5**
**80639 München (DE)**

(56) References cited:
CN-A- 101 207 386      CN-A- 101 471 673
CN-A- 108 365 849      CN-A- 109 921 802
CN-A- 110 289 933      US-A1- 2004 034 828
US-A1- 2019 273 511

• **QUALCOMM INCORPORATED: "Design of multiple family LDPC codes", vol. RAN WG1, no. Athens, Greece; 20170213 - 20170217, 12 February 2017 (2017-02-12), XP051210584, Retrieved from the Internet <URL:http://www.3gpp.org/ftp/Meetings_3GPP_SYNC/RAN1/Docs/> [retrieved on 20170212]**
• **HOCEVAR D E: "A Reduced Complexity Decoder Architecture via Layered Decoding of LDPC Codes", PROC., IEEE WORKSHOP ON SIGNAL PROCESSING SYSTEMS, SIPS 2004, 13-15 OCTOBER 2004, IEEE, 13 October 2004 (2004-10-13), pages 107 - 112, XP010743944, ISBN: 978-0-7803-8504-7, DOI: 10.1109/SIPS.2004.1363033**
• **CATT: "Offset optimization on base matrices for LDPC design", vol. RAN WG1, no. Hangzhou, China; 20170515 - 20170519, 14 May 2017 (2017-05-14), XP051272730, Retrieved from the Internet <URL:http://www.3gpp.org/ftp/Meetings_3GPP_SYNC/RAN1/Docs/> [retrieved on 20170514]**
• **ROTH C ET AL: "Area, throughput, and energy-efficiency trade-offs in the VLSI implementation of LDPC decoders", PROC., IEEE INTERNATIONAL SYMPOSIUM ON CIRCUITS AND SYSTEMS (ISCAS), 2011 , IEEE, 15 May 2011 (2011-05-15), pages 1772 - 1775, XP031997987, ISBN: 978-1-4244-9473-6, DOI: 10.1109/ISCAS.2011.5937927**

- YUMING ZHU ET AL: "A Reduced-Complexity, Scalable Implementation of Low Density Parity Check (LDPC) Decoder", PROC., IEEE WORKSHOP ON SIGNAL PROCESSING SYSTEMS DESIGN AND IMPLEMENTATION : BANFF, CANADA, OCTOBER 2 - 4 2006, IEEE, PISCATAWAY, NJ, 2 October 2006 (2006-10-02) - 4 October 2006 (2006-10-04), pages 83 - 88, XP031080520, ISBN: 978-1-4244-0382-0

- ERICSSON: "LDPC Code Design", vol. RAN WG1, no. Spokane, USA; 20170116 - 20170120, 16 January 2017 (2017-01-16), XP051207651, Retrieved from the Internet <URL:http://www.3gpp.org/ftp/Meetings_3GPP_SYNC/RAN1/Docs/> [retrieved on 20170116]

**Description**

**TECHNICAL FIELD**

This application relates to the communications field, and in particular, to a data processing method and a decoder and a computer program product and a computer-readable storage medium.

**BACKGROUND**

Quasi-cyclic low-density parity-check (quasi-cyclic Low-density Parity-check, QC-LDPC) is a common type of LDPC code, which has a feature of a flexible structure, and may be used as a check code, and is usually represented as a check matrix. Specifically, a transmit end may encode, by using a preset check matrix, an information sequence that needs to be sent, to generate a code word sequence, and send the code word sequence to a receive end. After receiving a code word sequence code, the receive end may decode the code word sequence by using a same check matrix to obtain the information sequence.

A commonly used decoding algorithm includes a layered decoding algorithm (layered decoding algorithm, LDA). During implementation of the LDA, a check base matrix is vertically divided into several layers based on rows of the base matrix, and is used layer by layer during decoding, to update a code word sequence. Each time a layer is used, an obtained new sequence is used as an input value, and the new sequence is updated by using a next layer of the check matrix, until a last layer of the check matrix is used. An obtained latest sequence is used as an information sequence.

It is assumed that the check matrix is a matrix of an order $m \times n$, an extension factor of the base matrix of the check matrix is Z, and the base matrix is a matrix of an order $m_b \times n_b$, where $m_b = m/Z$ and $n_b = n/Z$. Currently, in terms of hardware cooperation, the LDA is mainly implemented by using a row-level parallel solution. In the row-level parallel solution, $n_b$ variable nodes and Z check nodes need to be disposed, and the code word sequence is calculated by using a row in each layer of the check matrix. If a check matrix is relatively large, relatively more hardware resources are required, and costs are relatively high.

Document US 2004/0034828 A1 refers to low density parity check (LDPC) code that is particularly well adapted for hardware implementation of a belief propagation decoder circuit. The LDPC code is arranged as a macro matrix whose rows and columns represent block columns and block rows of a corresponding parity check matrix. Each non-zero entry corresponds to a permutation matrix, such as a cyclically shifted identity matrix, with the shift corresponding to the position of the permutation matrix entry in the macro matrix. The block columns of the macro matrix are grouped, so that only one column in the macro matrix group contributes to the parity check sum in any given row. The decoder circuitry includes a parity check value estimate memory which may be arranged in banks that can be logically connected in various data widths and depths. A parallel adder generates extrinsic estimates that are applied to parity check update circuitry for generating new parity check value estimates. These parity check value estimates are stored back into the memory, and are forwarded to bit update circuits for updating of probability values for the input nodes. Variations including parallelism, time-sequencing of ultrawide parity check rows, and pairing of circuitry to handle ultrawide code rows, are also disclosed.

3GPP document R1-1702642, "Design of multiple family LDPC codes", from Qualcomm Incorporated, 3GPP TSG-RAN WG1 #88, 13th - 17th February 2017, Athens, Greece, discusses that peak throughput determines the computational resource parallelism and complexity of both edge- and rowparallel decoder architectures. The throughput of both edge-parallel and node-parallel LDPC decoders is proportional to the lift size up to the parallelism-level constraint.

Document Dale E. Hocevar, "A Reduced Complexity Decoder Architecture via Layered Decoding of LDPC Codes" in PROC., IEEE WORKSHOP ON SIGNAL PROCESSING SYSTEMS, SIPS 2004, 13-15 OCTOBER 2004, DOI: 10.1109/SIPS.2004.1363033, discusses to apply layered belief propagation decoding to previously devised irregular partitioned permutation LDPC codes.

3GPP document R1-1707522, "Offset optimization on base matrices for LDPC design" from CATT, 3GPP TSG RAN WG1 Meeting #89, Hangzhou, China, 15th - 19th May 2017, proposes that in a well-designed QC-LDPC code's H matrix, the first offsets can be set to zero by matrix transformation, introducing no performance loss of the code. This method helps cut clock cycles and is completely pervasive for all QC-LDPC codes. In a well designed LDPC code's basic matrix, the difference of the adjacent offsets can be raised by elementary transformation of rows with no performance loss. This method helps to cut clock cycles and is completely pervasive to all QC-LDPC codes.

Document C. Roth et al.," Area, Throughput, and Energy-Efficiency Trade-offs in the VLSI Implementation of LDPC Decoders" in PROC., IEEE INTERNATIONAL SYMPOSIUM ON CIRCUITS AND SYSTEMS (ISCAS), 2011, IEEE, 15 May 2011, pages 1772-1775, DOI: 10.1109/ISCAS.2011.5937927, refers to Low-density parity-check (LDPC) codes that are key ingredients for improving reliability of modem communication systems and storage devices.

3GPP document R1-1700108, "LDPC Code Design" from Ericsson, 3GPP TSG RAN WG1 AH NR Meeting, Spokane, USA, 16th - 20th January 2017, proposes to adopt multiple base graphs to provide sufficient code size and code rate flexibility for NR, to use diagonal extension in parity matrix construction to provide incremental redundancy (IR) HARQ for NR, to use power-of-2 expansion factors (i.e., lifting sizes Z) for QC-LDPC as much as possible, and that for the QC-LDPC design, the non-zero sub-blocks have circulant weight =1.

## SUMMARY

Embodiments of this application provide a data processing method and a decoder and a computer program product and a computer-readable storage medium, to decode a code word sequence. The present invention is defined by the attached set of claims. Embodiments and aspects which are not covered by the invention should be considered as examples useful for understanding the invention.

## BRIEF DESCRIPTION OF DRAWINGS

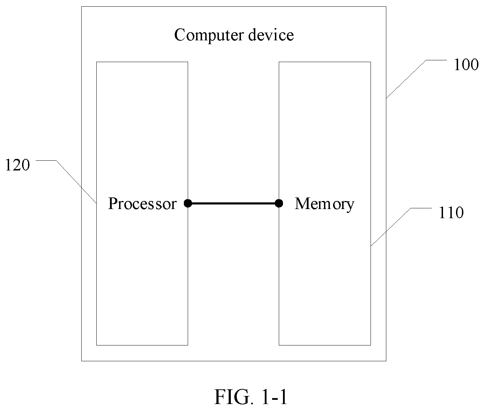

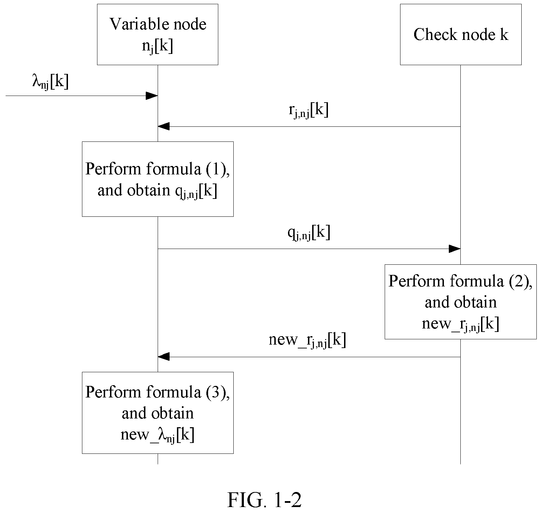

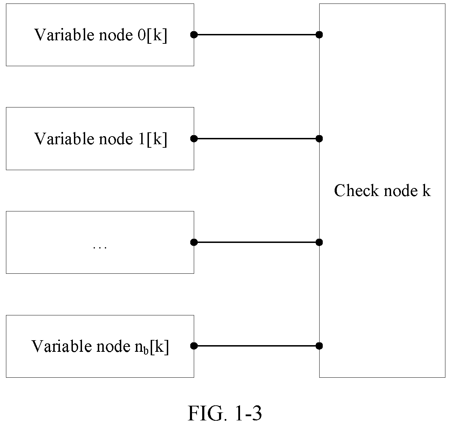

FIG. 1-1 is a schematic diagram of a computer device in this application;
FIG. 1-2 is a schematic diagram of a process of interaction between a variable node and a check node;
FIG. 1-3 is a schematic diagram of a structure including a variable node and a check node;
FIG. 2-1 is a schematic diagram of a data processing method according to this application;
FIG. 2-2 is a schematic diagram of a preset matrix in a raptor-like structure;

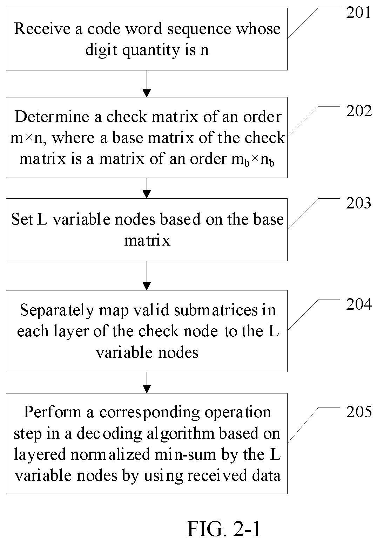

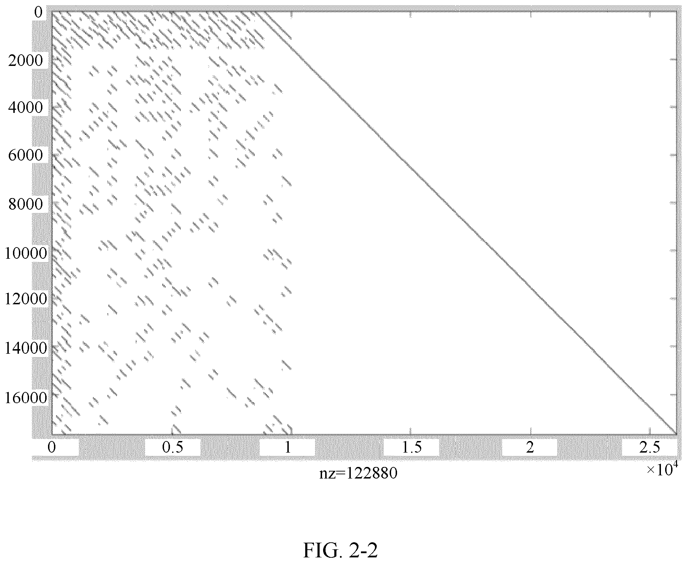

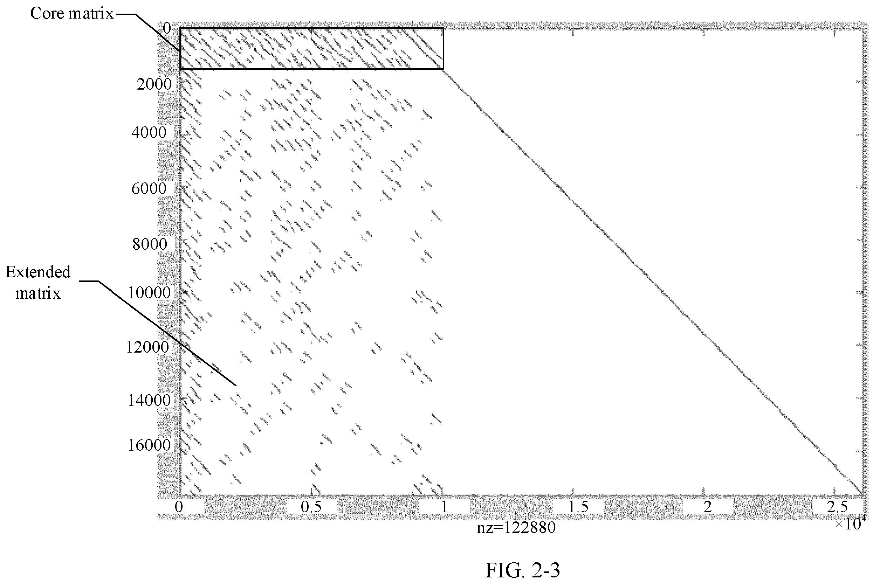

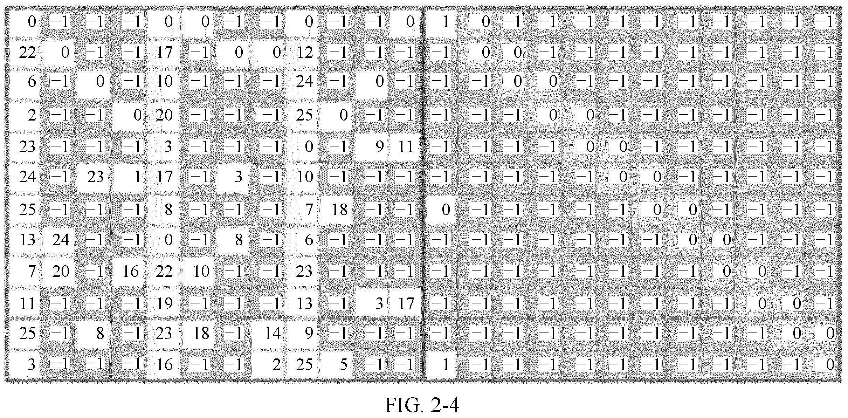

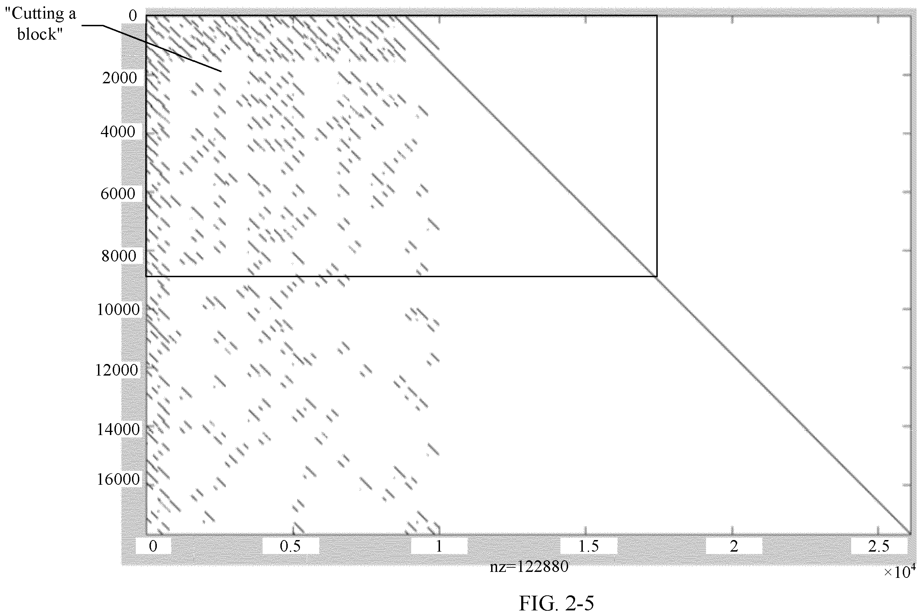

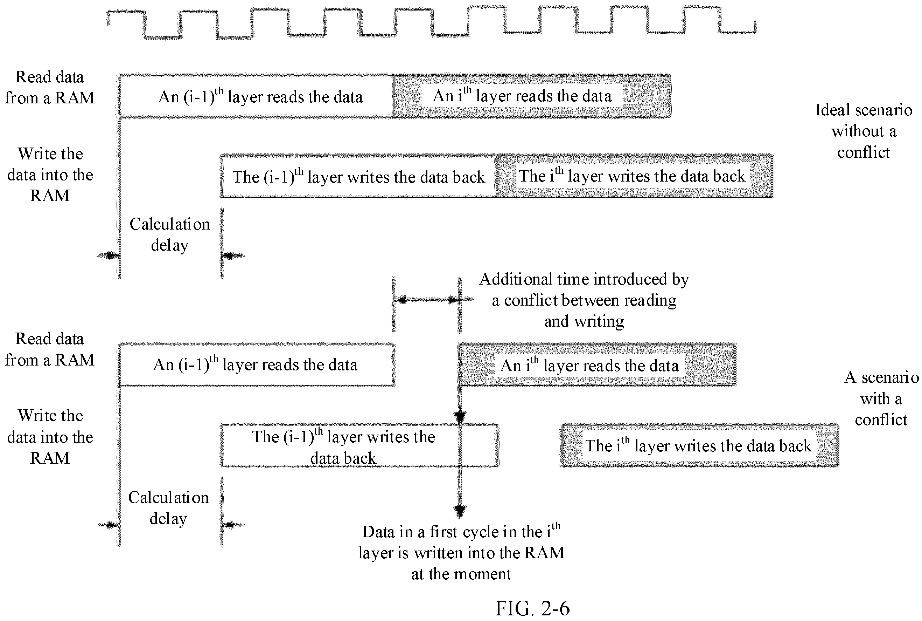

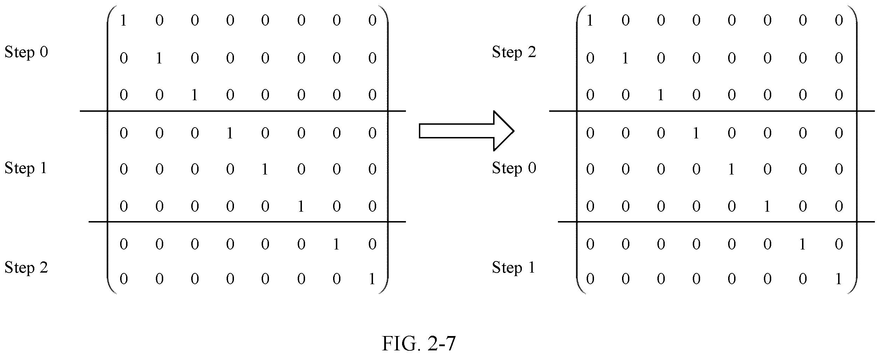

FIG. 2-3 is a schematic diagram of a core matrix and an extended matrix in a preset matrix;
FIG. 2-4 is a schematic diagram of a core matrix;
FIG. 2-5 is a schematic diagram of a manner of obtaining a check matrix;
FIG. 2-6 is a schematic diagram of a conflict between reading and writing;
FIG. 2-7 is a schematic diagram of dividing one layer of a check matrix into three sublayer matrices; and

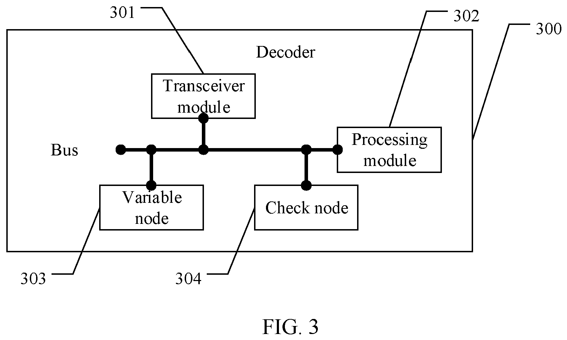

FIG. 3 is a schematic diagram of a decoder according to this application.

## DESCRIPTION OF EMBODIMENTS

Embodiments of this application provide a data processing method and a decoder, to decode a code word sequence.

In this application, terms such as "first", "second", "third", and "fourth" (if exists) in the specification, the claims, and the accompanying drawings are intended to distinguish between similar objects but do not necessarily indicate a specific order or sequence. It should be understood that the data used in such a way are interchangeable in proper cases so that embodiments described herein can be implemented in other orders than the order illustrated or described herein. In addition, the terms "include", "contain" and any other variants mean to cover the non-exclusive inclusion, for example, a process, method, system, product, or device that includes a list of steps or units is not necessarily limited to those steps or units, but may include other steps or units not expressly listed or inherent to such a process, method, product, or device.

A QC-LDPC code is a common type of LDPC code, and a check matrix H of the QC-LDPC code includes a series of element submatrices of an order $Z \times Z$, where $Z$ is referred to as an extension factor or dimension of the element submatrix. Each element submatrix is a cyclic right shift of a zero matrix or an identity matrix. Therefore, the element submatrix may also be represented by a value. For example, the zero matrix is represented as -1, the identity matrix is represented as 0, and a cyclic right shift of the identity matrix is represented as an offset of a right shift of the identity matrix.

A check matrix may also be represented by a matrix with a relatively small quantity of rows and columns, and this matrix is referred to as a base matrix. Therefore, it may be learned that a base matrix corresponding to a check matrix of an order $m \times n$ is a matrix of an order $m_b \times n_b$, where $m_b$ is equal to m/Z, and $n_b$ is equal to n/Z. It is clearly that, Z is divisible by m and n.

The following check matrix is used as an example for description. It is assumed that the check matrix is:

$$\begin{pmatrix} 1 & 0 & 0 & 0 & 0 & 1 & 1 & 0 \\ 0 & 1 & 0 & 0 & 1 & 0 & 0 & 1 \\ 1 & 0 & 0 & 0 & 1 & 0 & 1 & 0 \\ 0 & 1 & 0 & 0 & 0 & 1 & 0 & 1 \end{pmatrix}$$

Assuming that an extension factor is equal to 2, a base matrix of the check matrix may be obtained:

4

$$\begin{pmatrix} 0 & -1 & 1 & 0 \\ 0 & -1 & 0 & 0 \end{pmatrix}$$

In this way, storage burden can be reduced.

For another example, a check matrix with a relatively large data amount may be represented as the following base matrix of an order 4×11, where an extension factor of the base matrix is equal to 256.

$$\begin{pmatrix} 23 & -1 & 190 & 35 & 239 & 31 & 1 & 0 & -1 & -1 & -1 \\ 142 & 155 & -1 & 255 & -1 & 28 & 0 & 0 & 0 & -1 & -1 \\ -1 & 245 & 205 & 251 & 117 & -1 & -1 & -1 & 0 & 0 & -1 \\ 240 & 1 & 244 & -1 & 144 & 1 & 1 & -1 & -1 & 0 & -1 \end{pmatrix}$$

Each value in the base matrix may be extended to a matrix of an order 256×256. Therefore, only the base matrix may be stored without storing the check matrix. When being used, the matrix may be extended to the check matrix, which reduces storage burden and is very convenient.

After receiving a code word sequence, a receive end may decode the code word sequence by using a check matrix and a preset decoding algorithm, to obtain an information sequence. A common decoding algorithm includes a decoding algorithm based on layered normalized min-sum. The decoding algorithm based on layered normalized min-sum can effectively reduce hardware complexity and significantly reduce a quantity of decoding iterations, and therefore is widely used in decoder design.

When the decoding algorithm based on layered normalized min-sum is implemented, the check matrix is first vertically divided into several layers. For example, a submatrix that is of the check matrix and represented by a row of a base matrix is used as a layer of the check matrix. To be specific, it is assumed that the check matrix is a matrix of an order $m \times n$, the base matrix of the check matrix is a matrix of an order $m_b \times n_b$, and an extension factor is Z, that is, $m_b = m/Z$ and $n_b = n/Z$, where Z is divisible by both m and n. This is equivalent to dividing the check matrix into $m_b$ layers, and each layer is a matrix of an order $Z \times n_b$. The foregoing described check matrix represented by the basis matrix of an order 4×11 may be divided into four layers, and each layer is a matrix of an order 256×11.

When decoding is performed, $m_b$ rounds of decoding are separately performed, and a corresponding layer of the check matrix is used in each round. First, in a first round, the code word sequence is processed by using a first layer counted from top to down of the check matrix, to obtain a new sequence. Then, the new sequence is processed by using a second layer of the check matrix. By analogy, the code word sequence is iterated until a last layer of the check matrix is used, and a last obtained sequence is used as the information sequence.

Specifically, for a $j^{th}$ layer of the check matrix (which may be represented by a $j^{th}$ row of the base matrix, where a value of j is 0, 1, ..., mb-1), the code word sequence is decoded by using the following three formulas:

$$(1) \quad q_{j,n_j}[k] = \lambda_{n_j}[k] - r_{j,n_j}[k] \quad \left( n_j \in N(j) \right)$$

$$(2) \quad new\_r_{j,n_j}[k] = \left( \prod_{n_j' \in \{V(j) \backslash n_j\}} sign(q_{j,n_j'}[k]) \right) \cdot \left( \min_{n_j' \in \{V(j) \backslash n_j\}} \{ |q_{j,n_j'}[k]| \} \cdot \alpha \right)$$

$$(3) \quad new\_\lambda_{n_j}[k] = q_{j,n_j}[k] + new\_r_{j,n_j}[k]$$

In the foregoing formulas, $n_j$ represents a sequence number of a column of the base matrix from left to right and has a value of 0, 1, ..., $n_b$. In addition, N(j) represents a set of columns in which all values not equal to -1 in the $j^{th}$ row of the base matrix are located, where for the check matrix represented by the base matrix of an order 4×11, N(j) includes 0, 2, 3, 4, 5, 6, and 7; k represents a sequence number of a row in a layer of the check matrix and has a value of 0, 1, ..., Z-1; $\lambda$ represents an input code word sequence, that is, a received code word sequence or a code word sequence obtained after iteration in a previous layer, where for the check matrix of an order $m \times n$, $\lambda$ may have n values; r represents a cyclic variable, which is used to be updated and iterated together with a code word sequence, to be used as an input value of a next layer, and also has n values, where an initial value of r may be set to 0; q represents an intermediate variable and is used to update and iterate $\lambda$ in an operation (operations in the foregoing three formulas); $\alpha$ represents a correction factor and usually has a value of about 0.8; $V(j) \backslash n_j$ represents a set of values other than $n_j$ in N(j); sign() represents a symbol function, to be specific, if a parameter of the symbol function is greater than 0, a value is 1; if a parameter is less than 0, a value is -1; or if a parameter is equal to 0, a value is 0; $\Pi$ represents a cumulative product function; and min() represents a minimum function.

Through the foregoing three formulas, the code word sequence is iterated by using the check matrix to finally obtain the information sequence. To be specific, the code word sequence is first operated by using the first layer of the check matrix to obtain $new\_r_{j,nj}[k]$ and $new\_\Lambda_{nj}[k]$. Then, $new\_r_{j,nj}[k]$ and $new\_\Lambda_{nj}[k]$ are used as an input value to continue to be operated by continuing to use a next layer of the check matrix, until all layers of the check matrix are used. A finally obtained new code word sequence is used as the information sequence.

In this embodiment of this application, in terms of hardware, the code word sequence needs to be operated by a variable node and a check node by using the check matrix. The variable node is configured to perform formula (1), and then deliver an obtained result to the check node, so that the check node performs formula (2), and then returns an obtained result to the variable node. The variable node performs formula (3) to complete one iteration related to $\lambda$.

For better description, an architecture in this application is briefly described below.

To cooperate with the foregoing operation process, refer to FIG. 1-1, a computer device 100 needs to be used in this application. The computer device 100 includes a memory 110 and a processing module 120. The processing module 120 is configured to operate a code word sequence by using a check matrix. A plurality of variable nodes and a plurality of check nodes are disposed in the processing module 120. The variable node is configured to receive a code word sequence, and the check node is configured to store and provide a check matrix to the variable node.

As shown in FIG. 1-2, the variable node is configured to: receive $\lambda_{nj}[k]$ (whose initial value is a code word sequence), receive $r_{j,nj}[k]$ (whose initial value may be all 0) sent by the check node, perform formula (1) to obtain $q_{j,nj}[k]$ through calculation, and send $q_{j,nj}[k]$ to the check node. After receiving q sent by the variable node, the check node performs formula (2) to obtain $new\_r_{j,nj}[k]$ through calculation, sends the new $new\_r_{j,nj}[k]$ to the variable node, and uses $new\_r$ as r used for calculation in a next layer. Finally, the variable node performs formula (3) to obtain $new\_r_{j,nj}[k]$ through calculation, which is used as $\lambda$ used for calculation in a next layer, that is, $\lambda_{j+1,nj}[k]$.

To improve efficiency and reduce waste of nodes, a proper quantity of variable nodes and check nodes and a proper interaction manner need to be determined. Currently, a row-level parallel solution is mainly used to arrange variable nodes and check nodes.

In the row-level parallel solution, $n_b$ variable nodes and Z check nodes are disposed, where the $n_b$ variable nodes are in a one-to-one correspondence with $n_b$ columns of a base matrix, the $n_b$ variable nodes simultaneously perform formula (1), and send calculation results to a same check node. The Z check nodes are in a one-to-one correspondence with rows in each layer of a check matrix. The check node performs formula (2), and sends an obtained result to the variable node. The variable node performs formula (3) to obtain $\lambda$ and r that are required in a next layer. Due to an orthogonal feature of QC-LDPC, Z structures shown in FIG. 1-3 can be simultaneously processed.

For a layer of the check matrix, columns of the base matrix are orthogonal, and therefore the $n_b$ variable nodes simultaneously perform an operation. Because rows in a same layer of the check matrix are also orthogonal, the rows can be simultaneously used to perform operations for a same code word sequence by the rows, and the Z check nodes can be simultaneously performed and used, to improve efficiency.

The row-level parallel solution may provide calculation efficiency. However, if $n_b$ is relatively large or Z is relatively large, relatively more hardware resources (variable nodes or check nodes) are required, resulting in relatively high costs. In particular, in a current 5G technology, a maximum used extension factor Z of a base matrix of a QC-LDPC code may be 384, and a maximum $n_b$ may be 68. Therefore, it is difficult to be directly implemented based on the row-level parallel solution. In addition, the base matrix of the QC-LDPC code usually has a feature of sparsity. In many cases, a quantity of valid nodes in a row is far less than a total quantity of $n_b$ nodes. Consequently, node resources are wasted in the row-level parallel solution.

Therefore, this application provides a data processing method and a system. When a code word sequence whose digit quantity is n is received, a check matrix of an order m×n is determined. A base matrix of the check matrix is a matrix of an order $m_b \times n_b$, where $m_b$ is equal to m/Z, $n_b$ is equal to n/Z, and Z is an extension factor of the base matrix, both m and Z are positive integers, and Z is divisible by both m and n. Then, L variable nodes are set based on the base matrix, where L is equal to a quantity of values not equal to -1 in a row with a maximum quantity of values not equal to -1 in the base matrix, and the value not equal to -1 in the base matrix represents a non-zero submatrix of an order Z×Z in the check matrix. Therefore, a layered normalized min-sum decoding algorithm is performed by using a relatively small quantity of L variable nodes, and relatively few hardware resources are required, thereby effectively reducing costs.

Specifically, refer to FIG. 2-1. An embodiment of this application provides a data processing method, which includes the following steps.

201. Receive a code word sequence whose digit quantity is n, where n is a positive integer.

In a communication process, a transmit end performs channel encoding on an information sequence based on a check matrix to obtain a code word sequence. A receive end obtains the code word sequence, and transmits the obtained corresponding code word sequence through a channel, and may perform channel decoding on the code word sequence based on a check matrix or a base matrix by using a preset decoding algorithm, to obtain the information sequence included in the code word sequence.

For example, n is equal to 8, and the code word sequence has eight digits, which are respectively represented by $\lambda$ as follows:

$\lambda_0=3$, $\lambda_1=2$, $\lambda_2=-5$, $\lambda_3=-7$, $\lambda_4=4$, $\lambda_5=1$, $\lambda_6=-9$, and $\lambda_7=10$

202. Determine a check matrix of an order $m \times n$, where a base matrix of the check matrix is a matrix of an order $m_b \times n_b$, $m_b$ is equal to m/Z, $n_b$ is equal to n/Z, Z is an extension factor of the base matrix, both m and Z are positive integers, and Z is divisible by both m and n.

In this embodiment of this application, the base matrix of an order $m_b \times n_b$ may be first determined based on n, Z, and a preset matrix having a raptor-like (raptor-like) structure, and then the base matrix is extended to obtain the check matrix of an order $m \times n$.

It should be noted that the check matrix in a raptor-like structure includes two parts: a core matrix and an extended matrix. The core matrix may be in a form similar to a bidiagonal form in 802.11n, and supports a high bit rate. The extended matrix is in a form of single-column recheck and supports a low bit rate. Different bit rates can be flexibly obtained by selecting and using different quantities $m_b$ of rows of the base matrix.

For example, FIG. 2-2 is a schematic diagram of a preset matrix in a raptor-like structure. Because the preset matrix has an excessively large data amount, the preset matrix is replaced by a slash in FIG. 2-2. A part through which the slash passes represents 1 in the check matrix, and a remaining part represents 0. Each submatrix of an order $Z \times Z$ represents an offset of a zero matrix, an identity matrix, or an identity matrix, and indicates that the submatrix is an identity matrix or an offset of the identity submatrix.

As shown in FIG. 2-3, a part in a black box at an upper left corner is the core matrix (as shown in FIG. 2-4), and a remaining part is the extended matrix.

A preset matrix in a raptor-like structure is preset in each of the transmit end and the receive end. The transmit end determines a required base matrix from the preset matrix based on an information sequence that needs to be sent. This is similar to "cutting a block from the preset matrix" (as shown in FIG. 2-5). Then a code word sequence is encoded by using a check matrix represented by the base matrix, to obtain a code word sequence and send the code word sequence to the receive end. After receiving the code word sequence whose digit quantity is n, the receive end determines $n_b$ ($n_b$=n/Z) based on preset Z; then determines $m_b$ based on $n_b$ and the preset matrix, that is, "cutting" the base matrix of an order $m_b \times n_b$ from the preset matrix; and finally determines the check matrix represented by the base matrix. Then, the receive end extends the base matrix based on Z to obtain the check matrix.

203. Set L variable nodes based on the base matrix, where L is equal to a quantity of values not equal to -1 in a row with a maximum quantity of values not equal to -1 in the base matrix, and the value not equal to -1 in the base matrix represents a non-zero submatrix of an order $Z \times Z$ in the check matrix.

It should be noted that there are three values in the base matrix: -1, 0, and an integer greater than 0, where -1 represents a zero matrix of an order $Z \times Z$ in the check matrix, 0 represents an identity matrix of an order $Z \times Z$ in the check matrix, and an integer greater than 0 represents an offset of an identity matrix of an order $Z \times Z$. Therefore, the non--1 value in the base matrix represents 0 or an integer greater than 0.

For example, Z is equal to 6, and an element submatrix of an order $Z \times Z$ is a matrix of an order $6 \times 6$. In this case, -1 represents a zero matrix;

$$\begin{pmatrix} 0 & 0 & 0 & 0 & 0 & 0 \\ 0 & 0 & 0 & 0 & 0 & 0 \\ 0 & 0 & 0 & 0 & 0 & 0 \\ 0 & 0 & 0 & 0 & 0 & 0 \\ 0 & 0 & 0 & 0 & 0 & 0 \\ 0 & 0 & 0 & 0 & 0 & 0 \end{pmatrix}$$

0 represents an identity matrix;

$$\begin{pmatrix} 1 & 0 & 0 & 0 & 0 & 0 \\ 0 & 1 & 0 & 0 & 0 & 0 \\ 0 & 0 & 1 & 0 & 0 & 0 \\ 0 & 0 & 0 & 1 & 0 & 0 \\ 0 & 0 & 0 & 0 & 1 & 0 \\ 0 & 0 & 0 & 0 & 0 & 1 \end{pmatrix}$$

1 indicates that the identity matrix is shifted by 1 bit to the right;

$$\begin{pmatrix} 0 & 1 & 0 & 0 & 0 & 0 \\ 0 & 0 & 1 & 0 & 0 & 0 \\ 0 & 0 & 0 & 1 & 0 & 0 \\ 0 & 0 & 0 & 0 & 1 & 0 \\ 0 & 0 & 0 & 0 & 0 & 1 \\ 1 & 0 & 0 & 0 & 0 & 0 \end{pmatrix}$$

2 indicates that the identity matrix is shifted by 2 bits to the right;

$$\begin{pmatrix} 0 & 0 & 1 & 0 & 0 & 0 \\ 0 & 0 & 0 & 1 & 0 & 0 \\ 0 & 0 & 0 & 0 & 1 & 0 \\ 0 & 0 & 0 & 0 & 0 & 1 \\ 1 & 0 & 0 & 0 & 0 & 0 \\ 0 & 1 & 0 & 0 & 0 & 0 \end{pmatrix}$$

and so on.

The base matrix has $m_b$ rows, a row weight of each row is a quantity of values not equal to -1 in the row, and the quantity of values not equal to -1 in the row with a maximum quantity of values not equal to -1 in the rows of the base matrix is a maximum row weight of the base matrix. For example, for the following base matrix, a row weight of a zero[th] row is 3, a row weight of a first row is 2. In this case, a row with a maximum quantity of values not equal to -1 is the zero[th] row. The row weight of the row is 3, and therefore a maximum row weight of the base matrix is 3.

$$H_b = \begin{pmatrix} 0 & -1 & 1 & 0 \\ 0 & -1 & -1 & 0 \end{pmatrix}$$

In this embodiment of this application, the L variable nodes is disposed based on the maximum row weight of the base matrix, where L is equal to the maximum row weight of the base and L is set to be equal to the maximum row weight of the base matrix.

203. Separately map valid submatrices in each layer of the check node to the L variable nodes, where different valid submatrices correspond to different variable node.

It should be noted that a layer of the check node is a submatrix represented by a row of the base matrix.

For example, for the following check matrix,

$$\begin{pmatrix} 1 & 0 & 0 & 0 & 0 & 0 & 1 & 0 \\ 0 & 1 & 0 & 0 & 0 & 0 & 0 & 1 \\ 1 & 0 & 0 & 0 & 0 & 1 & 1 & 0 \\ 0 & 1 & 0 & 0 & 1 & 0 & 0 & 1 \end{pmatrix}$$

an extension factor of a base matrix of the check matrix is 2, that is, the base matrix is:

$$\begin{pmatrix} 0 & -1 & -1 & 0 \\ 0 & -1 & 1 & 0 \end{pmatrix}$$

In this case, a zeroth row of the base matrix represents a submatrix in a zeroth row layer of the check matrix, that is:

$$\begin{pmatrix} 1 & 0 & 0 & 0 & 0 & 0 & 1 & 0 \\ 0 & 1 & 0 & 0 & 0 & 0 & 0 & 1 \end{pmatrix}$$

The zeroth row of the base matrix represents a submatrix in the zeroth row layer of the check matrix, that is:

$$\begin{pmatrix} 1 & 0 & 0 & 0 & 0 & 1 & 1 & 0 \\ 0 & 1 & 0 & 0 & 1 & 0 & 0 & 1 \end{pmatrix}$$

In addition, the valid submatrix is a submatrix represented by the value not equal to -1 in the base matrix. A valid submatrix of the foregoing base matrix is a submatrix that is of the check matrix and that is represented by 0 and 1, and valid nodes in the zeroth layer of the check matrix are respectively as follows:

$$\begin{pmatrix} 1 & 0 \\ 0 & 1 \end{pmatrix}\begin{pmatrix} 1 & 0 \\ 0 & 1 \end{pmatrix}$$

Valid nodes in a first layer of the check matrix are respectively as follows:

$$\begin{pmatrix} 1 & 0 \\ 0 & 1 \end{pmatrix}\begin{pmatrix} 1 & 0 \\ 0 & 1 \end{pmatrix}\begin{pmatrix} 1 & 0 \\ 0 & 1 \end{pmatrix}$$

Because the maximum row weight of the check matrix is 3, L is set to be equal to 3, to obtain a variable node 0, a variable node 1, and a variable node 2. Therefore, valid submatrices in each layer of the check node are mapped to the L variable nodes to obtain the following, where different valid submatrices correspond to different variable node.

$$\begin{pmatrix} 1 & 0 \\ 0 & 1 \end{pmatrix} \text{->Variable node 0}$$

$$\begin{pmatrix} 1 & 0 \\ 0 & 1 \end{pmatrix} \text{->Variable node 1}$$

The valid submatrices in each layer of the check node are mapped to the L variable nodes to obtain the following, where different valid submatrices correspond to different variable node.

$$\begin{pmatrix} 1 & 0 \\ 0 & 1 \end{pmatrix} \text{->Variable node 0}$$

$$\begin{pmatrix} 1 & 0 \\ 0 & 1 \end{pmatrix} \text{->Variable node 1}$$

$$\begin{pmatrix} 1 & 0 \\ 0 & 1 \end{pmatrix} \text{->Variable node 2}$$

204. Send, to each of the L mapped variable nodes, data corresponding to each valid submatrix in each layer of the check matrix.

205. Perform a corresponding operation step in the layered normalized min-sum decoding algorithm by the L variable nodes by using the received data.

It should be noted that this embodiment of this application is implemented by the layered normalized min-sum decoding algorithm. Specifically, for a $j^{th}$ layer of the check matrix (which may be represented by a $j^{th}$ row of the base matrix, where a value of j is 0, 1, ..., mb-1), the code word sequence is decoded by using the following three formulas:

$$(1) \quad q_{j,n_j}[k] = \lambda_{n_j}[k] - r_{j,n_j}[k] \quad \left( n_j \in N(j) \right)$$

$$(2) \quad \text{new}\_r_{j,n_j}[k] = ( \prod_{n_j' \in \{V(j) \backslash n_j\}} \text{sign}(q_{j,n_j'}[k])) \cdot ( \min_{n_j' \in \{V(j) \backslash n_j\}} \{ \left| q_{j,n_j'}[k] \right| \} \cdot \alpha)$$

$$(3) \quad \text{new}\_\lambda_{n_j}[k] = q_{j,n_j}[k] + \text{new}\_r_{j,n_j}[k]$$

In the foregoing formulas, $n_j$ represents a sequence number of a column of the base matrix from left to right and has a value of 0, 1, ..., $n_b$. In addition, N(j) represents a set of columns in which all values not equal to -1 in the $j^{th}$ row of the base matrix are located, where for the check matrix represented by the base matrix of an order $4 \times 11$, N(j) includes 0, 2, 3, 4, 5, 6, and 7; k represents a sequence number of a row in a layer of the check matrix and has a value of 0, 1, ..., Z-1; $\lambda$ represents an input code word sequence, that is, a received code word sequence or a code word sequence obtained after iteration in a previous layer, where for the check matrix of an order $m \times n$, $\lambda$ may have n values; r represents a cyclic variable, which is used to be updated and iterated together with a code word sequence, to be used as an input value of a next layer, and also has n values, where an initial value of r may be set to 0; q represents an intermediate variable and is used to update and iterate $\lambda$ in an operation (operations in the foregoing three formulas); $\alpha$ represents a correction factor and usually has a value of about 0.8; $V(j) \backslash n_j$ represents a set of values other than $n_j$ in N(j); sign() represents a symbol function, to be specific, if a parameter of the symbol function is greater than 0, a value is 1; if a parameter is less than 0, a value is -1; or if a parameter is equal to 0, a value is 0; $\Pi$ represents a cumulative product function; and min() represents a minimum function.

Through the foregoing three formulas, the code word sequence is iterated by using the check matrix to finally obtain the information sequence. To be specific, the code word sequence is first operated by using the first layer of the check matrix to obtain new_$r_{j,nj}$[k] and new_$\Lambda_{nj}$[k]; then new_$r_{j,nj}$[k] and new_$\Lambda_{nj}$[k] are used as an input value to continue to be operated by continuing to use a next layer of the check matrix, until all layers of the check matrix are used; and a finally obtained new code word sequence is used as the information sequence.

In this embodiment of this application, in terms of hardware, the code word sequence needs to be operated by a variable node and a check node by using the check matrix. The variable node is configured to perform formula (1), and then deliver an obtained result to the check node, so that the check node performs formula (2), and then returns an obtained result to the variable node. The variable node performs formula (3) to complete one iteration related to $\lambda$.

In this embodiment of this application, because mapping of the valid submatrices in each layer of the check node to the L variable nodes is determined, there is no need to dispose $n_b$ variable nodes, and only L variable nodes need to be disposed, to complete calculation of the code word sequence.

The following uses an example for description.

It is assumed that a quantity of values of $\lambda$ is 8, that is, a code word sequence of eight digits is received, and it is assumed that $\lambda_0$=3, $\lambda_1$=2, $\lambda_2$=-5, $\lambda_3$=-7, $\lambda_4$=4, $\lambda_5$=1, $\lambda_6$=-9, and $\lambda_7$=10.

It is assumed that the check matrix is:

$$H = \begin{pmatrix} 1 & 0 & 0 & 0 & 0 & 1 & 1 & 0 \\ 0 & 1 & 0 & 0 & 1 & 0 & 0 & 1 \\ 1 & 0 & 0 & 0 & 1 & 0 & 1 & 0 \\ 0 & 1 & 0 & 0 & 0 & 1 & 0 & 1 \end{pmatrix}$$

A base matrix whose extension factor of the check matrix is 2 is:

$$H_b = \begin{pmatrix} 0 & -1 & 1 & 0 \\ 0 & -1 & 0 & 0 \end{pmatrix}$$

An operation processing is performed on the code word sequence by using a first layer of the check matrix (the check matrix includes two layers in total, and each layer includes two rows), and an input value is the received code word sequence. It may be learned that $\lambda_{nj}[k]$ is a $k^{th}$ row that is of the check matrix and that is represented by an $n_j^{th}$ row of the base matrix. To be specific, when j=0, values of n are respectively 0, 2, and 3, that is, a code word sequence that needs to be processed is $\lambda_0[0]=\lambda_0$, $\lambda_2[0]=\lambda_5$, $\lambda_3[0]=\lambda_6$, $\lambda_0[1]=\lambda_1$, $\lambda_2[1]=\lambda_4$, $\lambda_3[1]=\lambda_7$, and so on. After operation processing is performed on $\lambda_{nj}[k]$, a new sequence is obtained. The new sequence is used as an input value of next layer, that is, a similar operation is performed when j=1.

In this embodiment of this application, there is no need to dispose four variable nodes. A maximum row weight (that is, 3) of the base matrix continues to be determined, and then it is determined that only variable nodes whose quantity is equal to the maximum row weight need to be disposed, that is, three variable nodes (which are respectively a variable node 0, a variable node 1, and a variable node 2) can be disposed. Then mapping from each valid node of the check matrix to each variable node is established, for example, in the zero$^{th}$ of the check node, the mapping is as follows:

$$\begin{pmatrix} 1 & 0 \\ 0 & 1 \end{pmatrix} \text{->Variable node 0}$$

$$\begin{pmatrix} 0 & 1 \\ 1 & 0 \end{pmatrix} \text{->Variable node 1}$$

$$\begin{pmatrix} 1 & 0 \\ 0 & 1 \end{pmatrix} \text{->Variable node 2}$$

In the first layer of the check node, the mapping is as follows:

$$\begin{pmatrix} 1 & 0 \\ 0 & 1 \end{pmatrix} \text{->Variable node 0}$$

$$\begin{pmatrix} 1 & 0 \\ 0 & 1 \end{pmatrix} \text{->Variable node 1}$$

$$\begin{pmatrix} 1 & 0 \\ 0 & 1 \end{pmatrix} \text{->Variable node 2}$$

The variable node is used to operate formulas (1) and (3), and the check node is used to operate formula (2).

First, for $\lambda_0=3$, $\lambda_1=2$, $\lambda_2=-5$, $\lambda_3=-7$, $\lambda_4=4$, $\lambda_5=1$, $\lambda_6=-9$, and $\lambda_7=10$, it is assumed that an initial value of r is 0, that is,

$r_{j,nj}[0]$ is 0. In this case, it may be determined according to formula (1) that $\lambda$ that needs to be calculated is $\lambda_0$, $\lambda_5$, and $\lambda_6$, and then $\lambda_0$ is sent to the variable node 0, $\lambda_5$ is sent to the variable node 1, and $\lambda_6$ is sent to the variable node 2, to obtain the following through calculation:

$$q_{0,0}\left[0\right]=\lambda_0\left[0\right]=\lambda_0=3$$

Formula (1): $\quad q_{0,2}\left[0\right]=\lambda_2\left[0\right]=\lambda_5=1$

$$q_{0,3}\left[0\right]=\lambda_3\left[0\right]=\lambda_6=-9$$

Then, $q_{0,0}$, $q_{0,2}$, and $q_{0,3}$ are sent to the check node, and the check node performs formula (2):

$$\text{new\_r}_{0,0}[0]=(1\cdot-1)\cdot\min(1,9)=-1$$

Formula (2): $\quad \text{new\_r}_{0,2}[0]=(1\cdot-1)\cdot\min(3,9)=-3$

$$\text{new\_r}_{0,3}[0]=(1\cdot1)\cdot\min(3,1)=1$$

After $\text{new\_r}_{0,0}[0]$, $\text{new\_r}_{0,2}[0]$, and $\text{new\_r}_{0,3}[0]$ are obtained, $\text{new\_r}_{0,0}[0]$, $\text{new\_r}_{0,2}[0]$, and $\text{new\_r}_{0,3}[0]$ are sent to the variable node, so that the variable node performs formula (3):

$$\text{new\_}\lambda_0\left[0\right]=q_{0,0}\left[0\right]+\text{new\_r}_{0,0}\left[0\right]=3\text{-}1=2$$

Formula (3): $\quad \text{new\_}\lambda_2\left[0\right]=q_{0,2}\left[0\right]+\text{new\_r}_{0,2}\left[0\right]=1\text{-}3=-2$

$$\text{new\_}\lambda_3\left[0\right]=q_{0,3}\left[0\right]+\text{new\_r}_{0,3}\left[0\right]=-9\text{+}1=-8$$

Therefore, $\text{new\_}\lambda_{0,0}[0]$, $\text{new\_}\lambda_{0,2}[0]$, and $\text{new\_}\lambda_{0,3}[0]$ are obtained, and the remaining $\lambda_1$, $\lambda_2$, $\lambda_3$, $\lambda_4$, and $\lambda_7$ all have no change.
Similarly, the foregoing three formulas may continue to be used by using a row k=1 to obtain:

$$q_{0,0}\left[1\right]=\lambda_0\left[1\right]=\lambda_1=2$$

Formula (1): $\quad q_{0,2}\left[1\right]=\lambda_2\left[1\right]=\lambda_4=4$

$$q_{0,3}\left[1\right]=\lambda3\left[1\right]=\lambda_7=10$$

$$\text{new\_r}_{0,0}[1]=(1\cdot-1)\cdot\min(1,9)=-1$$

Formula (2): $\quad \text{new\_r}_{0,2}[1]=(1\cdot-1)\cdot\min(3,9)=-3$

$$\text{new\_r}_{0,3}[1]=(1\cdot1)\cdot\min(3,1)=1$$

$$\text{new\_}\lambda_0\left[1\right]=q_{0,0}\left[1\right]+\text{new\_r}_{0,0}\left[1\right]=3-1=2$$

Formula (3): $\quad \text{new\_}\lambda_2\left[1\right]=q_{0,2}\left[1\right]+\text{new\_r}_{0,2}\left[1\right]=1-3=-2$

$$\text{new\_}\lambda_3\left[1\right]=q_{0,3}\left[1\right]+\text{new\_r}_{0,3}\left[1\right]=-9+1=-8$$

After the foregoing operation, $\lambda_1$, $\lambda_4$, and $\lambda_7$ also change.
One layer of the check matrix has two rows, and after the code word sequence is operated by the two rows, an obtained new $\lambda$ is:
$\lambda_0$=2, $\lambda_1$=2, $\lambda_2$=-5, $\lambda_3$=-7, $\lambda_4$=-2, $\lambda_5$=-2, $\lambda_6$=-8, and $\lambda_7$=-8

Then, these sequences are delivered to a next layer as input values. Four variable nodes process these sequences in a same manner, and an obtained latest sequence is used as the information sequence.

After calculation performed by using a layer j=1 in the check matrix, the following is obtained:

$$\text{Formula (1):} \quad \begin{aligned} q_{1,0}[0] &= \lambda_0[0] = \lambda_0 = 2 \\ q_{1,2}[0] &= \lambda_2[0] = \lambda_4 = -2 \\ q_{1,3}[0] &= \lambda_3[0] = \lambda_6 = -8 \end{aligned}$$

$$\text{Formula (2):} \quad \begin{aligned} \text{new\_r}_{1,0}[0] &= (-1 \cdot -1) \cdot \min(2,8) = 2 \\ \text{new\_r}_{1,2}[0] &= (1 \cdot -1) \cdot \min(2,8) = -2 \\ \text{new\_r}_{1,3}[0] &= (1 \cdot -1) \cdot \min(2,2) = -2 \end{aligned}$$

$$\text{Formula (3):} \quad \begin{aligned} \text{new\_}\lambda_0[0] &= q_{1,0}[0] + \text{new\_r}_{1,0}[0] = 2 - 2 = 0 \\ \text{new\_}\lambda_2[0] &= q_{1,2}[0] + \text{new\_r}_{1,2}[0] = -2 - (-2) = 0 \\ \text{new\_}\lambda_3[0] &= q_{1,3}[0] + \text{new\_r}_{1,3}[0] = -8 - (-2) = -6 \end{aligned}$$

Similarly, the foregoing three formulas may continue to be used by using a row k=1 to obtain:

$$\text{Formula (1):} \quad \begin{aligned} q_{1,0}[1] &= \lambda_0[1] = \lambda_1 = 2 \\ q_{1,2}[1] &= \lambda_2[1] = \lambda_5 = -2 \\ q_{1,3}[1] &= \lambda_3[1] = \lambda_7 = -8 \end{aligned}$$

$$\text{Formula (2):} \quad \begin{aligned} \text{new\_r}_{1,0}[1] &= (-1 \cdot -1) \cdot \min(2,8) = 2 \\ \text{new\_r}_{1,2}[1] &= (1 \cdot -1) \cdot \min(2,8) = -2 \\ \text{new\_r}_{1,3}[1] &= (1 \cdot -1) \cdot \min(2,2) = -2 \end{aligned}$$

$$\text{Formula (3):} \quad \begin{aligned} \text{new\_}\lambda_0[1] &= q_{1,0}[1] + \text{new\_r}_{1,0}[1] = 2 - 2 = 0 \\ \text{new\_}\lambda_2[1] &= q_{1,2}[1] + \text{new\_r}_{1,2}[1] = -2 - (-2) = 0 \\ \text{new\_}\lambda_3[1] &= q_{1,3}[1] + \text{new\_r}_{1,3}[1] = -8 - (-2) = -6 \end{aligned}$$

Therefore, a last information sequence is (0, 0, 0, -7, 0, -2, -6, -6).

For an example not falling under the scope of the claimed invention, Z check nodes are simultaneously performed to improve running efficiency. For embodiments of the present claimed invention, P check nodes are disposed, where P is a positive integer less than Z, each layer of the check matrix is divided into ceiling(Z/P) sublayers, ceiling() is a rounding up function, and each sublayer includes rows not exceeding P rows of the check matrix. When the layered normalized min-sum decoding algorithm is performed, rows in each sublayer of each layer of the check matrix separately correspond to the P check nodes, where different rows correspond to different check nodes. After receiving data, the P check nodes perform a corresponding operation step in the layered normalized min-sum decoding algorithm on the data by using a corresponding row in each sublayer.

For example, a layer of the check matrix has eight rows, that is, the extension factor Z of the base matrix is equal to 8. An identity matrix of the check matrix is used as an instance of a valid submatrix.

$$\begin{pmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \end{pmatrix}$$

Each layer of the check matrix is divided into ceiling(Z/P) sublayers, where ceiling() is a rounding up function, and each sublayer includes rows not exceeding P rows of the check matrix. Assuming that P=3, that is, ceiling(Z/P)=3, the following is obtained:

$$\begin{pmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ \hline 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ \hline 0 & 0 & 0 & 0 & 0 & 0 & 1 & 0 \\ 0 & 0 & 0 & 0 & 0 & 0 & 0 & 1 \end{pmatrix}$$

In this way, only P (that is, three) check nodes need to be disposed, which respectively perform and use operations of the foregoing sublayers 0, 1, and 2.

It should be noted that in a layered decoding algorithm, calculation of each layer depends on a calculation result of an upper layer. Because processing of a calculation unit (a variable node or a check node) has a specific delay, if data that needs to be read and that is processed in an $i^{th}$ layer is not written into a RAM after being processed in an $(i-1)^{th}$ layer, a conflict between reading and writing exists. In this case, additional waiting time needs to be introduced, which affects a throughput rate of a decoder, as shown in FIG. 2-6.

A conflict between processing in an upper layer and processing in a lower layer is related to quasi-cyclic matrix shift values of the two layers. Based on a quasi-cyclic feature of a QC-LDPC code, Z check nodes in a row of the base matrix are orthogonal, processing of the Z nodes has no sequence, and therefore results are the same. Same offset value transformation is added to all values not equal to -1 in a row of the base matrix, so that a sequence of the check nodes can be adjusted.

For example, as shown in FIG. 2-7, an operation sequence of the foregoing three sublayer matrices obtained through division is adjusted. A proper offset value is found to perform sequence transformation shown below on the matrix. When a transformed matrix is used, impact of a conflict between reading and writing on a throughput rate of a decoder can be alleviated to a specific extent.

Refer to FIG. 3. This application provides a decoder 300. The decoder 300 uses a decoding algorithm based on layered normalized min-sum and includes: a transceiver module 301, a processing module 302, and L variable nodes 303.

The transceiver module 301 is configured to receive a code word sequence whose digit quantity is n, where n is a positive integer.

The processing module 302 is configured to determine a check matrix of an order $m \times n$, where a base matrix of the check matrix is a matrix of an order $m_b \times n_b$, $m_b$ is equal to m/Z, $n_b$ is equal to n/Z, Z is an extension factor of the base matrix, both m and Z are positive integers, and Z is divisible by both m and n.

The processing module 302 is further configured to set L variable nodes based on the base matrix, where L is equal to a quantity of values not equal to -1 in a row with a maximum quantity of values not equal to -1 in the base matrix, and the value not equal to -1 in the base matrix represents a non-zero submatrix of an order $Z \times Z$ in the check matrix.

The processing module 302 is further configured to: separately map valid submatrices in each layer of the check node to the L variable nodes, where different valid submatrices are mapped to different variable nodes, the valid submatrix is a submatrix represented by the value not equal to -1 in the base matrix, and a layer of the check node is a submatrix represented by a row of the base matrix. The processing module is further configured to send, to each of the L mapped variable nodes, data corresponding to each valid submatrix in each layer of the check matrix.

The L variable nodes 303 are configured to perform a corresponding operation step in the layered normalized min-sum decoding algorithm by using the received data.

In some feasible embodiments, the processing unit 302 is specifically configured to:

determine the base matrix of an order $m_b \times n_b$ based on n, Z, and a preset matrix having a raptor-like structure; and extend the base matrix to obtain the check matrix of an order $m \times n$.

The processing unit 302 is further configured to:
set P check nodes, where P is a positive integer less than Z, each layer of the check matrix is divided into ceiling(Z/P) sublayers, ceiling() is a rounding up function, and each sublayer includes rows not exceeding P rows of the check matrix.

The decoder further includes: P check nodes 304, configured to: separately make rows in each sublayer of each layer of the check matrix to be corresponding to the P check nodes, where different rows correspond to different check nodes; receive data; and perform a corresponding operation step in the layered normalized min-sum decoding algorithm on the data by using a corresponding row in each sublayer.

The processing unit 302 is further configured to:
determine an offset value, and adjust, based on the offset value, a sequence of using sublayers of a layer of the check matrix.

All or some of the foregoing embodiments may be implemented by using software, hardware, firmware, or any combination thereof. When software is used to implement embodiments, the embodiments may be implemented completely or partially in a form of a computer program product.

The computer program product includes one or more computer instructions. When the computer program instructions are loaded and executed on a computer, all or some of the procedures or the functions according to embodiments of the present invention are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (SSD)), or the like.

It may be clearly understood by a person skilled in the art that, for purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed systems, apparatuses, and methods may be implemented in other manners. For example, the described apparatus embodiments are merely examples. For example, the unit division is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located at one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units are integrated into one unit. The integrated unit may be implemented in a form of hardware, or may be implemented in a form of a software function unit.

When the integrated unit is implemented in the form of a software function unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, or a network device) to perform all or some of the steps of the methods described in embodiments of this application. The storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing embodiments are merely intended for describing the technical solutions of this application, but not for limiting this application.

**Claims**

1. A data processing method, wherein the method uses a layered normalized min-sum decoding algorithm and a quasi-cyclic low-density parity-check, QC-LDPC, code and comprises:

   receiving (201) a code word sequence whose digit quantity is n, wherein n is a positive integer;
   determining (202) a check matrix of the QC-LDPC code, the check matrix having an order $m \times n$, wherein a base matrix of the check matrix is a matrix of an order $m_b \times n_b$, $m_b$ is equal to m/Z, $n_b$ is equal to n/Z, Z is an extension factor of the base matrix, both m and Z are positive integers, and both m and n are divisible by Z, where a -1 in the base matrix represents a zero matrix of order ZxZ in the check matrix, a 0 in the base represents an identity matrix of order ZxZ in the check matrix and an integer greater than 0 in the base matrix represents a shifted identity matrix of order ZxZ in the check matrix;
   setting (203) L variable nodes (303) based on the base matrix, wherein L is equal to a quantity of values not equal to -1 in a row with a maximum quantity of values not equal to -1 in the base matrix so that L is set to be equal to a maximum row weight of the base matrix;
   separately mapping (204) valid submatrices in each layer of the check matrix to the L variable nodes (303), wherein different valid submatrices are mapped to different variable nodes (303), the valid submatrix is a submatrix represented by the value not equal to -1 in the base matrix, and each one of the layers of the check matrix is a submatrix represented by a row of the base matrix;
   sending, to each of the L mapped variable nodes (303), data corresponding to each valid submatrix in each layer of the check matrix; and
   performing (205) a corresponding operation step in the layered normalized min-sum decoding algorithm by the L variable nodes (303) by using the received data,
   wherein the method further comprises:

      setting P check nodes (304), wherein P is a positive integer less than Z, each layer of the check matrix is divided into ceiling(Z/P) sublayers, ceiling() is a rounding up function, and each sublayer comprises rows not exceeding P rows of the check matrix; and
      separately making rows in each sublayer of each layer of the check matrix to be corresponding to the P check nodes (304), wherein different rows correspond to different check nodes (304); receiving data by using the P check nodes (304); and performing a corresponding operation step in the layered normalized min-sum decoding algorithm on the data by the P check nodes (304) by using the corresponding rows in each sublayer, and
      after the setting P check nodes (304), the method further comprises:
      and wherein a same offset value is determined and added to all values not equal to -1 in a row of the base matrix corresponding to a layer of the check matrix so that an operation sequence of the sublayers of said layer within the layered normalized min-sum decoding algorithm performed by the P check nodes (304) is adjusted.

2. The method according to claim 1, wherein $m_b$ rounds of decoding are separately performed, and a corresponding layer of the check matrix is used in each round, so that in a first round the code word sequence is processed by using a first layer counted from top to down of the check matrix, to obtain a new sequence, and then, the new sequence is processed by using a second layer of the check matrix, and analogously the code word sequence is iterated until a last layer of the check matrix is used, and a last obtained sequence is used as an information sequence,

   wherein for a $j^{th}$ layer of the check matrix which is represented by a $j^{th}$ row of the base matrix, where a value of j is 0, 1, ..., $m_b$-1), the code word sequence is decoded by using the following three formulas:

$$(1) \quad q_{j,n_j}[k] = \lambda_{n_j}[k] - r_{j,n_j}[k] \quad \left(n_j \in N(j)\right)$$

$$(2) \quad new\_r_{j,n_j}[k] = (\prod_{n_j' \in \{V(j)\backslash n_j\}} sign(q_{j,n_j'}[k])) \cdot (\min_{n_j' \in \{V(j)\backslash n_j\}} \{|q_{j,n_j'}[k]|\} \cdot \alpha)$$

$$(3) \quad new\_\lambda_{n_j}[k] = q_{j,n_j}[k] + new\_r_{j,n_j}[k],$$

wherein $n_j$ represents a sequence number of a column of the base matrix from left to right and has a value of 0, 1, ..., $n_b$, N(j) represents a set of columns in which all values not equal to -1 in the $j^{th}$ row of the base matrix are located;

k represents a sequence number of a row in a layer of the check matrix and has a value of 0, 1, ..., Z-1; $\lambda$ represents an input code word sequence, that is, a received code word sequence or a code word sequence obtained after iteration in a previous layer, $\lambda$ has n values; r represents a cyclic variable, which is used to be updated and iterated together with the code word sequence, to be used as an input value of a next layer, and also has n values, where an initial value of r is set to 0; q represents an intermediate variable and is used to update and iterate $\lambda$ in operations in the foregoing three formulas; $\alpha$ represents a correction factor; V(j)\$n_j$ represents a set of values other than $n_j$ in N(j); sign() represents a symbol function, so that if a parameter of the symbol function is greater than 0, a value is 1; if a parameter is less than 0, a value is -1; or if a parameter is equal to 0, a value is 0; $\Pi$ represents a cumulative product function; and min() represents a minimum function.

3. The method according to claim 1 or 2, wherein the determining a check matrix of the QC-LDPC code comprises:

determining the base matrix of the order $m_b \times n_b$ based on n, Z, and a preset matrix having a raptor-like structure; and
extending the base matrix to obtain the check matrix of the QC-LDPC code.

4. A decoder (300), wherein the decoder (300) uses a layered normalized min-sum decoding algorithm and a quasi-cyclic low-density parity-check, QC-LDPC, code and comprises:

a transceiver module (301), configured to receive a code word sequence whose digit quantity is n, wherein n is a positive integer; and
a processing module (302), configured to determine a check matrix of the QC-LDPC code having an order $m \times n$, wherein a base matrix of the check matrix is a matrix of an order $m_b \times n_b$, $m_b$ is equal to m/Z, $n_b$ is equal to n/Z, Z is an extension factor of the base matrix, both m and Z are positive integers, both m and n are divisible by Z, where a -1 in the base matrix represents a zero matrix of order ZxZ in the check matrix, a 0 in the base represents an identity matrix of order ZxZ in the check matrix and an integer greater than 0 in the base matrix represents a shifted identity matrix of order ZxZ in the check matrix; wherein
the processing module (302) is further configured to set L variable nodes (303) based on the base matrix, wherein L is equal to a quantity of values not equal to -1 in a row with a maximum quantity of values not equal to -1 in the base matrix so that L is set to be equal to a maximum row weight of the base matrix;
the processing module (302) is further configured to separately mapping valid submatrices in each layer of the check matrix to the L variable nodes (303), wherein different valid submatrices are mapped to different variable nodes (303), the valid submatrix is a submatrix represented by the value not equal to -1 in the base matrix, and a layer of the check node (304) is a submatrix represented by a row of the base matrix;
the processing module (302) is further configured to send, to each of the L mapped variable nodes (303), data corresponding to each valid submatrix in each layer of the check matrix; and
the L variable nodes (303) are configured to perform a corresponding operation step in the layered normalized min-sum decoding algorithm by using the received data,
wherein the processing module (302) is further configured to set P check nodes (304), wherein P is a positive integer less than Z, each layer of the check matrix is divided into ceiling(Z/P) sublayers, ceiling() is a rounding up function, and each sublayer comprises rows not exceeding P rows of the check matrix;
wherein the P check nodes (304) are configured to separately make rows in each sublayer of each layer of the check matrix to be corresponding to the P check nodes (304), wherein different rows correspond to different check nodes (304), receive data,
and perform a corresponding operation step in the layered normalized min-sum decoding algorithm on the data by usingecorresponding rows in each sublayer, and

wherein the processing module (302) is further configured to determine and add a same offset value to all values not equal to -1 in a row of the base matrix corresponding to a layer of the check matrix so that an operation sequence of the sublayers of said layer within the layered normalized min-sum decoding algorithm performed by the P check nodes (304) is adjusted.

5. The decoder (300) according to claim 4, wherein the processing module (302) is further specifically configured to:

   determine the base matrix of the order $m_b \times n_b$ based on n, Z, and a preset matrix having a raptor-like structure; and

   extend the base matrix to obtain the check matrix of the QC-LDPC code.

6. A computer program product comprising instructions which, when the program is executed by a computer, cause the computer to carry out the method according to any one of claims 1 to 3.

7. A computer-readable storage medium comprising instructions which when executed by a computer, cause the computer to carry out the method according to any one of claims 1 to 3.

**Patentansprüche**

1. Datenverarbeitungsverfahren, wobei das Verfahren einen geschichteten normalisierten Min-Sum-Decodierungsalgorithmus und einen quasizyklischen Paritätsprüfungscode niedriger Dichte, QC-LDPC-Code, verwendet und Folgendes umfasst:

   Empfangen (201) einer Codewortsequenz, deren Ziffernanzahl n beträgt, wobei n eine positive ganze Zahl ist; Bestimmen (202) einer Prüfmatrix des QC-LDPC-Codes, wobei die Prüfmatrix eine Ordnung m x n aufweist, wobei eine Basismatrix der Prüfmatrix eine Matrix einer Ordnung $m_b$ x $n_b$ ist, wobei $m_b$ gleich m/Z ist, $n_b$ gleich n/Z ist, Z ein Erweiterungsfaktor der Basismatrix ist, sowohl m als auch Z positive ganze Zahlen sind und sowohl m als auch n durch Z teilbar sind, wobei eine -1 in der Basismatrix eine Null-Matrix der Ordnung Z x Z in der Prüfmatrix darstellt, eine 0 in der Basismatrix eine Einheitsmatrix der Ordnung Z x Z in der Prüfmatrix darstellt und eine ganze Zahl größer 0 in der Basismatrix eine verschobene Einheitsmatrix der Ordnung Z x Z in der Prüfmatrix darstellt; Festlegen (203) von L variablen Knoten (303) basierend auf der Basismatrix, wobei L gleich einer Anzahl von Werten ungleich -1 in einer Zeile mit einer maximalen Anzahl von Werten ungleich -1 in der Basismatrix ist, sodass L gleich einem maximalen Zeilengewicht der Basismatrix gesetzt wird; separates Zuordnen (204) gültiger Teilmatrizen in jeder Schicht der Prüfmatrix zu den L variablen Knoten (303), wobei unterschiedliche gültige Teilmatrizen unterschiedlichen variablen Knoten (303) zugeordnet werden, die gültige Teilmatrix eine Teilmatrix ist, die durch den Wert ungleich -1 in der Basismatrix dargestellt wird, und jede der Schichten der Prüfmatrix eine Teilmatrix ist, die durch eine Zeile der Basismatrix dargestellt wird; Senden von Daten, die jeder gültigen Teilmatrix in jeder Schicht der Prüfmatrix entsprechen, an jeden der L zugeordneten variablen Knoten (303); und Ausführen (205) eines entsprechenden Operationsschritts in dem geschichteten normalisierten Min-Sum-Decodierungsalgorithmus durch die L variablen Knoten (303) durch Verwenden der empfangenen Daten, wobei das Verfahren ferner Folgendes umfasst:

   Festlegen von P Prüfknoten (304), wobei P eine positive ganze Zahl kleiner als Z ist, jede Schicht der Prüfmatrix in "ceiling"(Z/P) Teilschichten geteilt wird, "ceiling"() eine Aufrundungsfunktion ist und jede Teilschicht Zeilen umfasst, die P Zeilen der Prüfmatrix nicht überschreiten; und separates Veranlassen, dass Zeilen in jeder Teilschicht jeder Schicht der Prüfmatrix den P Prüfknoten (304) entsprechen, wobei unterschiedliche Zeilen unterschiedlichen Prüfknoten (304) entsprechen; Empfangen von Daten durch Verwenden der P Prüfknoten (304); und Ausführen eines entsprechenden Operationsschritts in dem geschichteten normalisierten Min-Sum-Decodierungsalgorithmus an den Daten durch die P Prüfknoten (304) durch Verwenden der entsprechenden Zeilen in jeder Teilschicht, und wobei das Verfahren nach dem Festlegen von P Prüfknoten (304) ferner Folgendes umfasst: wobei ein gleicher Offsetwert bestimmt und zu allen Werten ungleich -1 in einer Zeile der Basismatrix hinzugefügt wird, die einer Schicht der Prüfmatrix entspricht, sodass eine von den P Prüfknoten (304) durchgeführte Operationssequenz der Teilschichten der Schicht innerhalb des geschichteten normalisierten Min-Sum-Decodierungsalgorithmus angepasst wird.

**2.** Verfahren nach Anspruch 1, wobei $m_b$ Decodierungsrunden separat durchgeführt werden und in jeder Runde eine entsprechende Schicht der Prüfmatrix verwendet wird, sodass in einer ersten Runde die Codewortsequenz durch Verwenden einer ersten Schicht der Prüfmatrix von oben nach unten gezählt verarbeitet wird, um eine neue Sequenz zu erhalten, und dann die neue Sequenz durch Verwenden einer zweiten Schicht der Prüfmatrix verarbeitet wird und analog die Codewortsequenz iteriert wird, bis eine letzte Schicht der Prüfmatrix verwendet wird und eine zuletzt erhaltene Sequenz als Informationssequenz verwendet wird,

wobei für eine j-te Schicht der Prüfmatrix, die durch eine j-te Zeile der Basismatrix dargestellt wird, wobei ein Wert von j 0, 1, ..., $m_b$ - 1 ist, die Codewortsequenz durch Verwenden der folgenden drei Formeln decodiert wird:

$$(1) \quad q_{j,n_j}[k] = \lambda_{n_j}[k] - r_{j,n_j}[k] \quad \left(n_j \in N(j)\right)$$

$$(2) \quad \text{new}\_r_{j,n_j}[k] = \left(\prod_{n_j \in V(j)\backslash n_j} \text{sign}(q_{j,n_j}[k])\right) \cdot \left(\min_{n_j \in V(j)\backslash n_j} \left\{\left|q_{j,n_j}[k]\right|\right\} \cdot \alpha\right)$$

$$(3) \quad \text{new}\_\lambda_{n_j}[k] = q_{j,n_j}[k] + \text{new}\_r_{j,n_j}[k],$$

wobei $n_j$ eine Folgenummer einer Spalte der Basismatrix von links nach rechts darstellt und einen Wert von 0, 1, ..., $n_b$ aufweist, N(j) einen Satz von Spalten darstellt, in der sich alle Werte ungleich -1 in der j-ten Zeile der Basismatrix befinden; k eine Folgenummer einer Zeile in einer Schicht der Prüfmatrix darstellt und einen Wert von 0, 1, ..., Z - 1 aufweist; λ eine eingegebene Codewortsequenz, das heißt eine empfangene Codewortsequenz oder eine nach der Iteration in einer vorherigen Schicht erhaltene Codewortsequenz darstellt, wobei λ n Werte aufweist; r eine zyklische Variable darstellt, die verwendet wird, um zusammen mit der Codewortsequenz aktualisiert und iteriert zu werden, um als Eingabewert einer nächsten Schicht verwendet zu werden, und ebenfalls n Werte aufweist, wobei ein Anfangswert von r auf 0 gesetzt ist; q eine Zwischenvariable darstellt und verwendet wird, um λ in Operationen in den vorhergehenden drei Formeln zu aktualisieren und zu iterieren; α einen Korrekturfaktor darstellt; V(j)\n$_j$ einen Satz von anderen Werten als n$_j$ in N(j) darstellt; sign() eine Symbolfunktion darstellt, sodass, wenn ein Parameter der Symbolfunktion größer als 0 ist, ein Wert 1 ist; wenn ein Parameter kleiner als 0 ist, ein Wert -1 ist; oder, wenn ein Parameter gleich 0 ist, ein Wert 0 ist; Π eine kumulative Produktfunktion darstellt und min() eine Minimumfunktion darstellt.

**3.** Verfahren nach Anspruch 1 oder 2, wobei das Bestimmen einer Prüfmatrix des QC-LDPC-Codes Folgendes umfasst:

Bestimmen der Basismatrix der Ordnung $m_b$ x $n_b$ basierend auf n, Z und einer voreingestellten Matrix mit einer raptorähnlichen Struktur;
und
Erweitern der Basismatrix, um die Prüfmatrix des QC-LDPC-Codes zu erhalten.

**4.** Decoder (300), wobei der Decoder (300) einen geschichteten normalisierten Min-Sum-Decodierungsalgorithmus und einen quasizyklischen Paritätsprüfungscode niedriger Dichte, QC-LDPC-Code, verwendet und Folgendes umfasst:

eine Sendeempfangsmodul (301), das zum Empfangen einer Codewortsequenz ausgelegt ist, deren Ziffernanzahl n beträgt, wobei n eine positive ganze Zahl ist; und ein Verarbeitungsmodul (302), das zum Bestimmen einer Prüfmatrix des QC-LDPC-Codes mit einer Ordnung m x n ausgelegt ist, wobei eine Basismatrix der Prüfmatrix eine Matrix einer Ordnung $m_b$ x $n_b$ ist, wobei $m_b$ gleich m/Z ist, $n_b$ gleich n/Z ist, Z ein Erweiterungsfaktor der Basismatrix ist, sowohl m als auch Z positive ganze Zahlen sind, sowohl m als auch n durch Z teilbar sind, wobei eine -1 in der Basismatrix eine Null-Matrix der Ordnung Z x Z in der Prüfmatrix darstellt, eine 0 in der Basismatrix eine Einheitsmatrix der Ordnung Z x Z in der Prüfmatrix darstellt und eine ganze Zahl größer 0 in der Basismatrix eine verschobene Einheitsmatrix der Ordnung Z x Z in der Prüfmatrix darstellt;
wobei
das Verarbeitungsmodul (302) ferner zum Festlegen von L variablen Knoten (303) basierend auf der Basismatrix ausgelegt ist, wobei L gleich einer Anzahl von Werten ungleich -1 in einer Zeile mit einer maximalen Anzahl von Werten ungleich -1 in der Basismatrix ist, sodass L gleich einem maximalen Zeilengewicht der Basismatrix gesetzt wird;
das Verarbeitungsmodul (302) ferner dazu ausgelegt ist, gültige Teilmatrizen in jeder Schicht der Prüfmatrix separat zu den L variablen Knoten (303) zuzuordnen, wobei unterschiedliche gültige Teilmatrizen unterschiedlichen variablen Knoten (303) zugeordnet werden, die gültige Teilmatrix eine Teilmatrix ist, die durch den Wert ungleich -1 in der Basismatrix dargestellt wird, und eine Schicht der Prüfknotens (304) eine Teilmatrix ist, die durch eine Zeile der Basismatrix dargestellt wird;

das Verarbeitungsmodul (302) ferner dazu ausgelegt ist, Daten, die jeder gültigen Teilmatrix in jeder Schicht der Prüfmatrix entsprechen, an jeden der L zugeordneten variablen Knoten (303) zu senden; und

die L variablen Knoten (303) dazu ausgelegt sind, einen entsprechenden Operationsschritt in dem geschichteten normalisierten Min-Sum-Decodierungsalgorithmus durch Verwenden der empfangenen Daten auszuführen;

wobei das Verarbeitungsmodul (302) ferner zum Festlegen von P Prüfknoten (304) ausgelegt ist, wobei P eine positive ganze Zahl kleiner als Z ist, jede Schicht der Prüfmatrix in "ceiling"(Z/P) Teilschichten geteilt wird, "ceiling"() eine Aufrundungsfunktion ist und jede Teilschicht Zeilen umfasst, die P Zeilen der Prüfmatrix nicht überschreiten;

wobei die P Prüfknoten (304) dazu ausgelegt sind, separat zu veranlassen, dass Zeilen in jeder Teilschicht jeder Schicht der Prüfmatrix den P Prüfknoten (304) entsprechen, wobei unterschiedliche Zeilen unterschiedlichen Prüfknoten (304) entsprechen; Daten zu empfangen und einen entsprechenden Operationsschritt in dem geschichteten normalisierten Min-Sum-Decodierungsalgorithmus an den Daten durch Verwenden entsprechender Zeilen in jeder Teilschicht auszuführen, und

wobei das Verarbeitungsmodul (302) ferner dazu ausgelegt ist, einen gleichen Offsetwert zu bestimmen und zu allen Werten ungleich -1 in einer Zeile der Basismatrix hinzuzufügen, die einer Schicht der Prüfmatrix entspricht, sodass eine von den P Prüfknoten (304) durchgeführte Operationssequenz der Teilschichten der Schicht innerhalb des geschichteten normalisierten Min-Sum-Decodierungsalgorithmus angepasst wird.

5. Decoder (300) nach Anspruch 4, wobei das Verarbeitungsmodul (302) ferner insbesondere zu Folgendem ausgelegt ist:

Bestimmen der Basismatrix der Ordnung $m_b \times n_b$ basierend auf n, Z und einer voreingestellten Matrix mit einer raptorähnlichen Struktur;
und
Erweitern der Basismatrix, um die Prüfmatrix des QC-LDPC-Codes zu erhalten.

6. Computerprogrammprodukt, umfassend Anweisungen, die bei Ausführung des Programms durch einen Computer den Computer zum Durchführen des Verfahrens nach einem der Ansprüche 1 bis 3 veranlassen.

7. Computerlesbares Speichermedium, umfassend Anweisungen, die bei Ausführung durch einen Computer den Computer zum Durchführen des Verfahrens nach einem der Ansprüche 1 bis 3 veranlassen.


**Revendications**

1. Procédé de traitement de données, le procédé utilisant un algorithme de décodage par somme minimale normalisée en couches et un code à contrôle de parité quasi-cyclique de faible densité, QC-LDPC, et comprenant :

la réception (201) d'une séquence de mots de code dont la quantité de chiffres est n, n étant un nombre entier positif ;
la détermination (202) d'une matrice de contrôle du code QC-LDPC, la matrice de contrôle ayant
un ordre m×n, une matrice de base de la matrice de contrôle étant une matrice d'un ordre $m_b \times n_b$, $m_b$ étant égal à m/Z, $n_b$ étant égal à n/Z, Z étant un facteur d'extension de la matrice de base, m et Z étant tous deux des nombres entiers positifs, et m et n étant tous deux divisibles par Z, un -1 dans la matrice de base représentant une matrice zéro d'ordre Z×Z dans la matrice de contrôle, un 0 dans la base représentant une matrice identité d'ordre Z×Z dans la matrice de contrôle et un nombre entier supérieur à 0 dans la matrice de base représentant une matrice identité décalée d'ordre Z×Z dans la matrice de contrôle ;
la définition (203) de L nœuds variables (303) en fonction de la matrice de base, L étant égal à une quantité de valeurs non égales à -1 dans une rangée avec une quantité maximale de valeurs non égales à -1 dans la matrice de base, de sorte que L soit égal à un poids de rangée maximal de la matrice de base ;
la mise en correspondance séparément (204) des sous-matrices valides dans chaque couche de la matrice de contrôle avec les L nœuds variables (303), différentes sous-matrices valides étant mises en correspondance avec différents nœuds variables (303), la sous-matrice valide étant une sous-matrice représentée par la valeur non égale à -1 dans la matrice de base, et chacune des couches de la matrice de contrôle étant une sous-matrice représentée par une rangée de la matrice de base ;

l'envoi, à chacun des L nœuds variables mis en correspondance (303), de données correspondant à chaque sous-matrice valide dans chaque couche de la matrice de contrôle ; et

la réalisation (205) d'une étape d'opération correspondante dans l'algorithme de décodage par somme minimale normalisée en couches par les L nœuds variables (303) à l'aide des données reçues,

le procédé comprenant en outre :

la définition de P nœuds de contrôle (304), P étant un nombre entier positif inférieur à Z, chaque couche de la matrice de contrôle étant divisée en plafond(Z/P) sous-couches, plafond() étant une fonction d'arrondi, et chaque sous-couche comprenant des rangées ne dépassant pas P rangées de la matrice de contrôle ; et

l'établissement séparément de rangées dans chaque sous-couche de chaque couche de la matrice de contrôle pour correspondre aux P nœuds de contrôle (304), différentes rangées correspondant à différents nœuds de contrôle (304) ; la réception de données à l'aide des P nœuds de contrôle (304) ; et la réalisation d'une étape d'opération correspondante dans l'algorithme de décodage par somme minimale normalisée en couches sur les données par les P nœuds de contrôle (304) à l'aide des rangées correspondantes dans chaque sous-couche, et

après la définition de P nœuds de contrôle (304), le procédé comprenant en outre :

une même valeur de décalage étant déterminée et ajoutée à toutes les valeurs non égales à -1 dans une rangée de la matrice de base correspondant à une couche de la matrice de contrôle, de sorte qu'une séquence d'opérations des sous-couches de ladite couche au sein de l'algorithme de décodage par somme minimale normalisée en couches réalisée par les P nœuds de contrôle (304) est ajustée.

**2.** Procédé selon la revendication 1, $m_b$ tours de décodage étant réalisés séparément, et une couche de la matrice de contrôle correspondante étant utilisée dans chaque tour, de sorte que dans un premier tour, la séquence de mots de code est traitée à l'aide d'une première couche comptée de haut en bas de la matrice de contrôle, pour obtenir une nouvelle séquence, et ensuite, la nouvelle séquence étant traitée à l'aide d'une deuxième couche de la matrice de contrôle, et de façon analogue la séquence de mots de code étant itérée jusqu'à ce qu'une dernière couche de la matrice de contrôle soit utilisée, et une dernière séquence obtenue étant utilisée comme une séquence d'information,

pour une $j^{ième}$ couche de la matrice de contrôle représentée par une $j^{ième}$ rangée de la matrice de base, une valeur de j étant 0, 1, ..., $m_b$-1, la séquence de mots de code étant décodée à l'aide des trois formules suivantes :

$$(1) \quad q_{j,n_j}[k] = \lambda_{n_j}[k] - r_{j,n_j}[k] \quad \left(n_j \in N(j)\right)$$

$$(2) \quad \text{new\_}r_{j,n_j}[k] = (\prod_{n_j' \in \{V(j)\backslash n_j\}} \text{sign}(q_{j,n_j'}[k])) \cdot (\min_{n_j' \in \{V(j)\backslash n_j\}} \{|q_{j,n_j'}[k]|\} \cdot \alpha)$$

$$(3) \quad \text{new\_}\lambda_{n_j}[k] = q_{j,n_j}[k] + \text{new\_}r_{j,n_j}[k],$$

$n_j$ représentant un numéro de séquence d'une colonne de la matrice de base de gauche à droite et ayant une valeur de 0, 1, ..., $n_b$, N(j) représentant un ensemble de colonnes dans lesquelles se trouvent toutes les valeurs non égales à -1 dans la $j^{ième}$ rangée de la matrice de base ;

k représentant un numéro de séquence d'une rangée dans une couche de la matrice de contrôle et ayant une valeur de 0, 1, ..., Z-1 ; $\lambda$ représentant une séquence de mots de code en entrée, c'est-à-dire une séquence de mots de code reçue ou une séquence de mots de code obtenue après itération dans une couche précédente ; $\lambda$ ayant n valeurs ; r représentant une variable cyclique, qui est utilisée pour être mise à jour et itérée avec la séquence de mots de code, pour être utilisée comme valeur d'entrée d'une couche suivante, et ayant également n valeurs, une valeur initiale de r étant fixée à 0 ; q représentant une variable intermédiaire et étant utilisé pour mettre à jour et itérer $\lambda$ dans les opérations des trois formules précédentes ; $\alpha$ représentant un facteur de correction ; $V(j)\backslash n_j$ représentant un ensemble de valeurs autres que $n_j$, dans N(j) ; sign() représentant une fonction de symbole, de sorte que si un paramètre de la fonction de symbole est supérieur à 0, la valeur étant 1 ; si un paramètre est inférieur à 0, la valeur étant -1 ; ou si un paramètre est égal à 0, la valeur étant 0 ; $\prod$ représentant une fonction de produit cumulatif ; et min() représentant une fonction minimum.

3. Procédé selon la revendication 1 ou 2, la détermination d'une matrice de contrôle du code QC-LDPC comprenant :

la détermination de la matrice de base de l'ordre $m_b \times n_b$ en fonction de n, Z et d'une matrice prédéfinie ayant une structure de type raptor ; et

l'extension de la matrice de base pour obtenir la matrice de contrôle du code QC-LDPC.

4. Décodeur (300), le décodeur (300) utilisant un algorithme de décodage par somme minimale normalisée en couches et un code à contrôle de parité quasi-cyclique de faible densité, QC-LDPC, et comprenant :

un module émetteur-récepteur (301), configuré pour recevoir une séquence de mots de code dont la quantité de chiffres est n, n étant un nombre entier positif ; et

un module de traitement (302), configuré pour déterminer une matrice de contrôle du code QC-LDPC ayant un ordre m×n, une matrice de base de la matrice de contrôle étant une matrice d'un ordre $m_b \times n_b$, $m_b$ étant égal à m/Z, $n_b$ étant égal à n/Z, Z étant un facteur d'extension de la matrice de base, m et Z étant tous deux des nombres entiers positifs, m et n étant tous deux divisibles par Z, un -1 dans la matrice de base représentant une matrice zéro d'ordre Z×Z dans la matrice de contrôle, un 0 dans la base représentant une matrice identité d'ordre Z×Z dans la matrice de contrôle et un nombre entier supérieur à 0 dans la matrice de base représentant une matrice identité décalée d'ordre Z×Z dans la matrice de contrôle ;

le module de traitement (302) étant en outre configuré pour définir L nœuds variables (303) en fonction de la matrice de base, L étant égal à une quantité de valeurs non égales à -1 dans une rangée avec une quantité maximale de valeurs non égales à - 1 dans la matrice de base, de sorte que L soit égal à un poids de rangée maximal de la matrice de base ;

le module de traitement (302) étant en outre configuré pour mettre en correspondance séparément les sous-matrices valides dans chaque couche de la matrice de contrôle avec les L nœuds variables (303), différentes sous-matrices valides étant mises en correspondance avec différents nœuds variables (303), la sous-matrice valide étant une sous-matrice représentée par la valeur non égale à -1 dans la matrice de base, et une couche du nœud de contrôle (304) étant une sous-matrice représentée par une rangée de la matrice de base ;

le module de traitement (302) étant en outre configuré pour envoyer, à chacun des L nœuds variables mis en correspondance (303), des données correspondant à chaque sous-matrice valide dans chaque couche de la matrice de contrôle ; et

les L nœuds variables (303) étant configurés pour réaliser une étape d'opération correspondante dans l'algorithme de décodage par somme minimale normalisée en couches à l'aide des données reçues,

le module de traitement (302) étant en outre configuré pour définir P nœuds de contrôle (304), P étant un nombre entier positif inférieur à Z, chaque couche de la matrice de contrôle étant divisée en plafond(Z/P) sous-couches, plafond() étant une fonction d'arrondi, et chaque sous-couche comprenant des rangées ne dépassant pas P rangées de la matrice de contrôle ;

les P nœuds de contrôle (304) étant configurés pour créer séparément des rangées dans chaque sous-couche de chaque couche de la matrice de contrôle pour correspondre aux P nœuds de contrôle (304), différentes rangées correspondant à différents nœuds de contrôle (304), recevoir des données, et réaliser une étape d'opération correspondante dans l'algorithme de décodage par somme minimale normalisée en couches sur les données à l'aide des rangées correspondantes dans chaque sous-couche, et

le module de traitement (302) étant en outre configuré pour déterminer et ajouter une même valeur de décalage à toutes les valeurs non égales à -1 dans une rangée de la matrice de base correspondant à une couche de la matrice de contrôle, de sorte qu'une séquence d'opérations des sous-couches de ladite couche au sein de l'algorithme de décodage par somme minimale normalisée en couches réalisée par les P nœuds de contrôle (304) est ajustée.

5. Décodeur (300) selon la revendication 4, le module de traitement (302) étant en outre spécifiquement configuré pour :

déterminer la matrice de base de l'ordre $m_b \times n_b$ en fonction de n, Z et d'une matrice prédéfinie ayant une structure de type raptor ; et

étendre la matrice de base pour obtenir la matrice de contrôle du code QC-LDPC.

6. Produit de programme informatique comprenant des instructions qui, lorsque le programme est exécuté par un ordinateur, amènent l'ordinateur à mettre en œuvre le procédé selon l'une quelconque des revendications 1 à 3.

7. Support de stockage lisible par ordinateur comprenant des instructions qui, lorsqu'elles sont exécutées par un ordinateur, amènent l'ordinateur à mettre en œuvre le procédé selon l'une quelconque des revendications 1 à 3.

Computer device

Processor ●━━━━━● Memory

100

120

110

FIG. 1-1

FIG. 1-2

| | | |
|---|---|---|
| Variable node 0[k] | | |

Variable node 0[k] ●━━━━━━━━━●

Variable node 1[k] ●━━━━━━━━━●

... ●━━━━━━━━━●

Variable node $n_b$[k] ●━━━━━━━━━●

Check node k

FIG. 1-3

Receive a code word sequence whose
digit quantity is n — 201

↓

Determine a check matrix of an order
m×n, where a base matrix of the check
matrix is a matrix of an order $m_b \times n_b$ — 202

↓

Set L variable nodes based on the base
matrix — 203

↓

Separately map valid submatrices in
each layer of the check node to the L
variable nodes — 204

↓

Perform a corresponding operation
step in a decoding algorithm based on
layered normalized min-sum by the L
variable nodes by using received data — 205

FIG. 2-1

FIG. 2-2

FIG. 2-3

| 0 | −1 | −1 | −1 | 0 | 0 | −1 | −1 | 0 | −1 | −1 | 0 | 1 | 0 | −1 | −1 | −1 | −1 | −1 | −1 | −1 | −1 | −1 | −1 |
|---|---|---|---|---|---|---|---|---|---|---|---|---|---|---|---|---|---|---|---|---|---|---|---|
| 22 | 0 | −1 | −1 | 17 | −1 | 0 | 0 | 12 | −1 | −1 | −1 | −1 | 0 | 0 | −1 | −1 | −1 | −1 | −1 | −1 | −1 | −1 | −1 |
| 6 | −1 | 0 | −1 | 10 | −1 | −1 | −1 | 24 | −1 | 0 | −1 | −1 | −1 | 0 | 0 | −1 | −1 | −1 | −1 | −1 | −1 | −1 | −1 |
| 2 | −1 | −1 | 0 | 20 | −1 | −1 | −1 | 25 | 0 | −1 | −1 | −1 | −1 | −1 | 0 | 0 | −1 | −1 | −1 | −1 | −1 | −1 | −1 |
| 23 | −1 | −1 | −1 | 3 | −1 | −1 | −1 | 0 | −1 | 9 | 11 | −1 | −1 | −1 | −1 | 0 | 0 | −1 | −1 | −1 | −1 | −1 | −1 |
| 24 | −1 | 23 | 1 | 17 | −1 | 3 | −1 | 10 | −1 | −1 | −1 | −1 | −1 | −1 | −1 | −1 | 0 | 0 | −1 | −1 | −1 | −1 | −1 |
| 25 | −1 | −1 | −1 | 8 | −1 | −1 | −1 | 7 | 18 | −1 | −1 | 0 | −1 | −1 | −1 | −1 | −1 | 0 | 0 | −1 | −1 | −1 | −1 |
| 13 | 24 | −1 | −1 | 0 | −1 | 8 | −1 | 6 | −1 | −1 | −1 | −1 | −1 | −1 | −1 | −1 | −1 | −1 | 0 | 0 | −1 | −1 | −1 |
| 7 | 20 | −1 | 16 | 22 | 10 | −1 | −1 | 23 | −1 | −1 | −1 | −1 | −1 | −1 | −1 | −1 | −1 | −1 | −1 | 0 | 0 | −1 | −1 |
| 11 | −1 | −1 | −1 | 19 | −1 | −1 | −1 | 13 | −1 | 3 | 17 | −1 | −1 | −1 | −1 | −1 | −1 | −1 | −1 | −1 | 0 | 0 | −1 |
| 25 | −1 | 8 | −1 | 23 | 18 | −1 | 14 | 9 | −1 | −1 | −1 | −1 | −1 | −1 | −1 | −1 | −1 | −1 | −1 | −1 | −1 | 0 | 0 |
| 3 | −1 | −1 | −1 | 16 | −1 | −1 | 2 | 25 | 5 | −1 | −1 | 1 | −1 | −1 | −1 | −1 | −1 | −1 | −1 | −1 | −1 | −1 | 0 |

FIG. 2-4

"Cutting a block"

$nz=122880$

FIG. 2-5

EP 4 027 525 B1

Read data
from a RAM

| An (i-1)$^{th}$ layer reads the data | An i$^{th}$ layer reads the data |

Write the
data into the
RAM

| The (i-1)$^{th}$ layer writes the data back | The i$^{th}$ layer writes the data back |

Calculation
delay

Ideal scenario
without a
conflict

Additional time introduced by
a conflict between reading
and writing

Read data
from a RAM

| An (i-1)$^{th}$ layer reads the data | An i$^{th}$ layer reads the data |

Write the
data into the
RAM

| The (i-1)$^{th}$ layer writes the
data back | The i$^{th}$ layer writes the data back |

Calculation
delay

A scenario
with a
conflict

Data in a first cycle in the i$^{th}$
layer is written into the RAM
at the moment

FIG. 2-6

EP 4 027 525 B1

Step 0

Step 1

Step 2

$$
\begin{pmatrix}
1 & 0 & 0 & 0 & 0 & 0 & 0 & 0 \\
0 & 1 & 0 & 0 & 0 & 0 & 0 & 0 \\
0 & 0 & 1 & 0 & 0 & 0 & 0 & 0 \\
0 & 0 & 0 & 1 & 0 & 0 & 0 & 0 \\
0 & 0 & 0 & 0 & 1 & 0 & 0 & 0 \\
0 & 0 & 0 & 0 & 0 & 1 & 0 & 0 \\
0 & 0 & 0 & 0 & 0 & 0 & 1 & 0 \\
0 & 0 & 0 & 0 & 0 & 0 & 0 & 1
\end{pmatrix}
\Rightarrow
\begin{pmatrix}
1 & 0 & 0 & 0 & 0 & 0 & 0 & 0 \\
0 & 1 & 0 & 0 & 0 & 0 & 0 & 0 \\
0 & 0 & 1 & 0 & 0 & 0 & 0 & 0 \\
0 & 0 & 0 & 1 & 0 & 0 & 0 & 0 \\
0 & 0 & 0 & 0 & 1 & 0 & 0 & 0 \\
0 & 0 & 0 & 0 & 0 & 1 & 0 & 0 \\
0 & 0 & 0 & 0 & 0 & 0 & 1 & 0 \\
0 & 0 & 0 & 0 & 0 & 0 & 0 & 1
\end{pmatrix}
$$

Step 2

Step 0

Step 1

FIG. 2-7

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040034828 A1

**Non-patent literature cited in the description**

- **QUALCOMM INCORPORATED**. Design of multiple family LDPC codes. *3GPP TSG-RAN WG1 #88*, 13 February 2017
- **DALE E. HOCEVAR**. A Reduced Complexity Decoder Architecture via Layered Decoding of LDPC Codes. *PROC., IEEE WORKSHOP ON SIGNAL PROCESSING SYSTEMS*, 2004
- **CATT**. Offset optimization on base matrices for LDPC design. *3GPP TSG RAN WG1 Meeting #89*, 15 May 2017
- Area, Throughput, and Energy-Efficiency Trade-offs in the VLSI Implementation of LDPC Decoders. **C. ROTH et al.** PROC., IEEE INTERNATIONAL SYMPOSIUM ON CIRCUITS AND SYSTEMS (ISCAS). IEEE, 15 May 2011, 1772-1775
- **ERICSSON**. LDPC Code Design. *3GPP TSG RAN WG1 AH NR Meeting*, 16 January 2017